# EUROPEAN PATENT APPLICATION

(11) **EP 3 089 222 A1**
(43) Date of publication of application: **02.11.2016**
(21) Application number: 14874932.8
(22) Date of filing: 27.11.2014
(51) Int. Cl.: H01L 31/068

(54) **SOLAR CELL AND METHOD FOR MANUFACTURING SAME**

(30) Priority: 24.12.2013 JP 2013265749
(71) Applicant: Kubo, Masaharu, Tokyo 192-0043 (JP)
(72) Inventor: SAITO, Tadashi, Hamura-shi Tokyo 205-0002 (JP)
(74) Representative: Van Straaten, Joop
(86) International application number: PCT/JP2014/081450
(87) International publication number: WO 2015/098426

(57) **Abstract**

The problem to be solved by the present invention is to provide a solar battery which reduces obstructing circumstances in improvement of photoelectric conversion efficiency. The solar battery of the present invention comprises a semiconductor substrate of a first conductivity type, a first semiconductor layer of a second conductivity type formed along at a light transmitting surface of the semiconductor substrate and collecting photo-generated carriers based on solar beam of middle and long wavelength, and a second semiconductor layer of a second conductivity type formed at a light incident surface of the semiconductor substrate and collecting photo -generated carriers which cannot reach a first semiconductor layer among photo-generated carriers based on the solar beam of middle and long wavelength as well as collecting photo-generated carriers based on solar beam of short wavelength.

## Description

### TECHNICAL FIELD

The present invention relates to a photoelectric conversion device and a solar battery equipped therewith, more particularly to a solar battery and its manufacturing method using a crystal-based semiconductor such as a single crystal silicon and/or a polycrystalline silicon.

### BACKGROUND OF THE INVENTION

Conventionally, Japanese Patent Application Laid-Open No.11-224954 discloses some technologies for providing a solar battery with both high efficiency in taking out carriers and improved characteristics. This solar battery takes out minority carriers among photo-generated carriers generated in a crystal-based semiconductor layer by incidence of light through both sides of the crystal-based semiconductor layer. In other words, this solar battery is a solar battery comprising a first semiconductor layer having an opposite conductivity type at a light incident surface side on the crystal-based semiconductor layer having one conductivity type, and comprising a second semiconductor layer having an opposite conductivity type at a light transmitting surface side on the crystal-based semiconductor layer.

### SUMMARY OF THE INVENTION

### Problem to be solved by the Invention

However, in order to improve the performance of the solar battery, although it is indispensable to reduce recombination of photo -generated carriers and injected carriers, the solar battery disclosed in Japanese Patent Application Laid-Open No.11-224954 is not taken such correspondence. By this reason, there was a limit in improving the performance of the solar battery disclosed in Japanese Patent Application Laid-Open No.11-224954.

Furthermore, for the solar battery disclosed in Japanese Patent Application Laid-Open No.11-224954, since the semiconductor substrate constituting it is relatively thick, most of the minority carriers cannot reach the first semiconductor layer or the second semiconductor layers. By this reason, consequently, photo-generated carriers recombine themselves and an amount of current taken out from the first semiconductor layer or the second semiconductor layers was a little. Also, there is the problem that the increase in recombination electric current causes a decrease in open circuit voltage.

Thereby, the problem to be solved by the present invention is to provide a solar battery which reduces obstructing circumstances in improvement of photoelectric conversion efficiency.

### Means for Solving the Problem

In order to solve the problem described above, the solar battery of the present invention comprising:
a semiconductor substrate of a first conductivity type;
a first semiconductor layer of a second conductivity type formed at a light transmitting surface of the semiconductor substrate and collecting photo-generated carriers based on solar beam of middle and long wavelength; and
a second semiconductor layer of a second conductivity type formed at a light incident surface of the semiconductor substrate and collecting photo-generated carriers which do not reach a first semiconductor layer among photo-generated carriers based on the solar beam of middle and long wavelength as well as collecting photo-generated carriers based on solar beam of short wavelength;
wherein an impurity concentration of the second semiconductor layer is larger to almost one digit or more as compared with an impurity concentration of the first semiconductor layer.

According to the present invention, since the impurity concentration of the second semiconductor layer is larger to almost one digit or more as compared with that of the first semiconductor layer, it is possible to differentiate about 60[mV] or more between the built-in potential of the semiconductor substrate and the first semiconductor layer and the built-in potential of the semiconductor substrate and the second semiconductor layer. As a result, it is possible to take out about 90[%] or more of photo-generated carriers from the first semiconductor layer.

Further, it is preferable that the first semiconductor layer is formed in a manner in contact with overall to a light transmission surface of the semiconductor substrate except for formation locations of a semiconductor layer of a first conductive type connected to electrodes for taking out electric signals based on photo-generated carriers collected at the first semiconductor layer, so that decrease of open circuit voltage at the light transmitting surface of the semiconductor substrate may be prevented.

Furthermore, when the first semiconductor layer and the second semiconductor layer are manufactured by a same process, since it is possible to simplify a manufacturing process, there is also advantage of being able to reduce a manufacturing cost.

Moreover, it is desirable that the semiconductor substrate is covered with the first semiconductor layer and the second semiconductor layer except for formation locations of a semiconductor layer of a first conductive type connected to electrodes for taking out electric signals based on carriers collected at the first semiconductor layer. In a side surface of the semiconductor substrate, considerably, since it becomes possible to collect photo-generated carriers that do not reach the first semiconductor layer, recombination of photo-generated carriers may be further prevented.

Furthermore, a current value outputted from the first semiconductor layer may be larger than a current value outputted from the second semiconductor layer.

Furthermore, the manufacturing method of the present invention includes:
a step of forming a first semiconductor layer of a second conductivity type collecting carriers generated based on solar beam of middle and long wavelength at a light transmitting surface of a first conductivity type;
a step of forming a second semiconductor layer of a second conductivity type collecting carriers which do not reach a first semiconductor layer among carriers generated based on the solar beam of middle and long wavelength as well as collecting carriers generated based on solar beam of short wavelength at a light incident surface of the semiconductor substrate; and
a step of increasing an impurity concentration of the second semiconductor layer almost one digit or more as compared with an impurity concentration of the first semiconductor layer.

In accordance with the present invention, since the second semiconductor layer is formed in the semiconductor substrate, it makes possible to collect photo-generated carriers which do not reach the first semiconductor layer at the second semiconductor layer. Accordingly, it becomes possible to prevent the recombination of photo-generated carriers.

### BRIEF DESCRIPTION OF THE DRAWINGS

FIG. 1 is a schematic perspective view watched from a light incident surface side of a solar battery cell 100 constituting a solar battery of Embodiment 1 of the present invention.
FIG. 2 is a schematic perspective view watched from a light transmitting surface side being a back surface side of FIG. 1.
FIG. 3 is a sectional view taken along a broken line A in FIG. 1 and FIG. 2.
FIG. 4 is a manufacturing process diagram of a solar battery cell 100 shown in FIG. 3.
FIG. 5 is a schematic sectional view of the solar battery cell 100 of Embodiment 2 of the present invention.

### REFERENCE SIGNS LIST

31 antireflection film
32 oxide film
100 solar battery cell
101 single crystal N type semiconductor substrate
102A P type first semiconductor layer
102B P type second semiconductor layer
143 N+ type semiconductor layer
170 bus bar wiring
171 first electrode
172 second electrode
173 side surface electrode
174 main bus bar at a light incident surface

### DESCRIPTION OF THE PREFERRED EMBODIMENTS

Hereinafter, embodiments of the present invention will be described with reference to the drawings.

### Embodiment 1

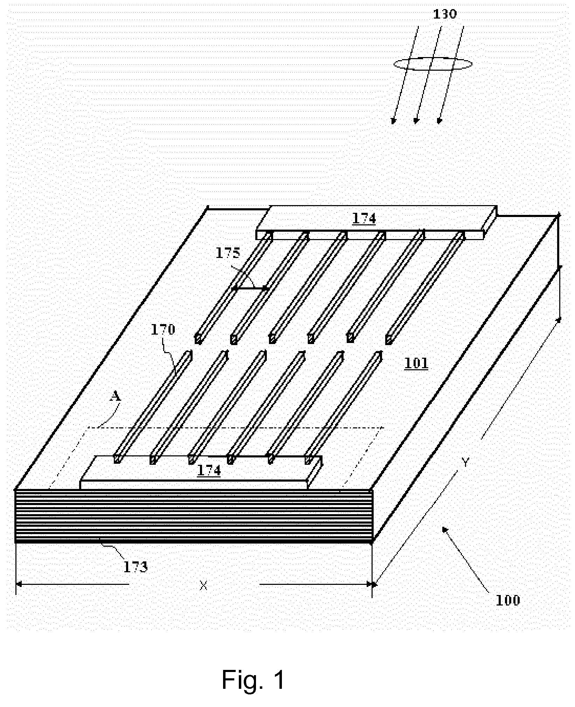

FIG. 1 is a schematic perspective view watched from a light incident surface side of the solar battery cell 100 constituting the solar battery of Embodiment 1 of the present invention. As shown in FIG. 1, the solar battery cell 100 comprises a single crystal N type semiconductor substrate 101, a bus bar wiring 170, a main bus bar at a light incident surface 174, and a side surface electrode 173 described below.

Further, in FIG. 1, a solar beam 130 and a pitch 175 between the bus bar wiring 170 are noted. As an example, the solar battery cell 100 may have a length in the X and Y direction as about 150[mm]-160[mm] and a thickness as about 150[µm]-200[µm].

In the single crystal N type semiconductor substrate 101, the specific resistance, for example, is 0.1[Ω·cm]-1[Ω·cm], the thickness, for example, is 150[µm]-200[µm], and, the impurity concentration is 10¹⁷[cm⁻³]-6 × 10¹⁶[cm⁻³]. However, in place of the single crystal N type semiconductor substrate 101, a polycrystalline N type semiconductor substrate may be used, and, by making in reverse type to a conductivity type of semiconductor described thereafter, a single crystal or polycrystalline P type semiconductor substrate may be used. In the present embodiment, since it is contributing to prevent the recombination of photo-generated carriers by making relatively thin the thickness of the single crystal N type semiconductor substrate 101, the photoelectric conversion efficiency may be improved.

The bus bar wiring 170 is a wiring formed on the light incident surface of the single crystal N type semiconductor substrate 101 along the Y direction. In here, for example, although a total of 12 pieces of the bus bar wiring 170 are schematically shown, actually, about 1000 pieces of wirings are formed. However, the number of the bus bar wiring 170 may be more or less than these numbers.

As an example, the bus bar wiring 170 is set with an electrode length of 75[mm], an electrode width of 3[µm], and a thickness of 3[µm]. In this condition, an aperture ratio of the solar battery cell 100 is about 99[%]. In addition, in the bus bar wiring 170, it is preferable to select the material of about 2.5 × 10⁻⁶[Ω•cm]-3.0 × 10⁶[Ω•cm]as the specific resistance.

As such a material, for example, aluminum, silver or copper may be used. These materials may be used, for example, in form of paste, and, may be used by mixing not only used in alone. The pitch 175 between the bus bar wiring 170 may be about 300[µm].

The main bus bar at a light incident surface 174 is formed along the X direction and is connected with each of the bus bar wiring 170. The size of the main bus bar at a light incident surface 174, for example, may be the one with a width of about 150[mm], a length of about 20[µm], and a thickness of about 3[µm].

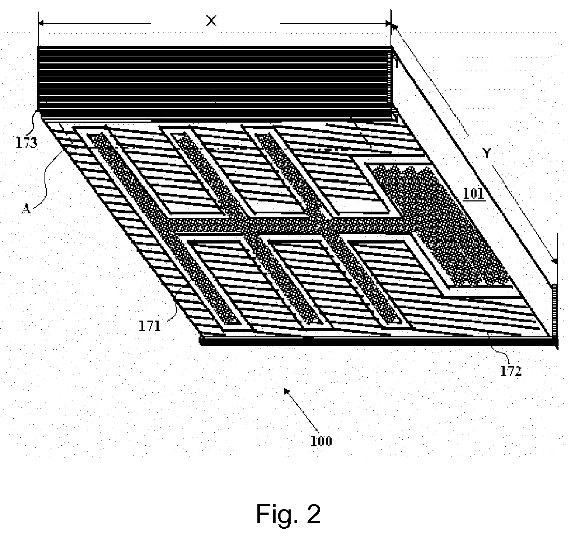

The side surface electrode 173 is formed on the side surface of the single crystal N type semiconductor substrate 101, and, is connected to the main bus bar at a light incident surface 174 and a second electrode 172 described below (FIG. 2). The size of the side surface electrode 173, for example, may be adopted the one with a length in the X direction of about 150[mm], a length in the Z direction orthogonal to the X and Y directions (not shown) of about 150[µm]-200[µm], and a thickness of about 3[µm].

Further, in the case of using aluminum as the material of the side surface electrode 173, as compared to the bus bar wiring 170, since the wiring resistance of the main bus bar at a light incident surface 174 is negligible, in the case of the size described above, the resistance value of the main bus bar at a light incident surface 174 is about 250[mΩ].

FIG. 2 is a schematic perspective view watched from a light transmitting surface side being a back surface side of FIG. 1. In FIG. 2, a first electrode 171 and a second electrode 172 described below are shown in addition to the parts shown in FIG. 1.

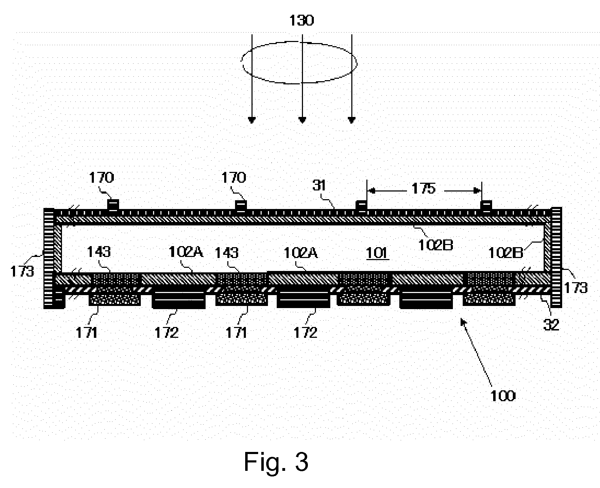

The first electrode 171 is an electrode which is connected to a N+ type semiconductor layer 143 described below (FIG. 3), and, takes out electric signals based on photo-generated carriers generated by the solar beam 130 through the N+ type semiconductor layer 143. The first electrode 171, for example, is constituted of an axis portion at which the central portion extends in the Y-direction, and a plurality of comb-shaped portion extending integrally in the X direction orthogonal to the axis portion.

Furthermore, the material of the first electrode 171, but is not limited to, for example, may be constituted of aluminum, and the thickness may be about 10[µm].

The second electrode 172 is an electrode which is connected to a P type first semiconductor layer 102A described below (FIG. 3), and, takes out electric signals based on photo-generated carriers generated by the solar beam 130 through the P type first semiconductor layer 102A.

The second electrode 172, for example, is formed with a predetermined inter-electrode gap such as 10[µm] around the first electrode 171. The second electrode 172, but is not limited to, for example, may be constituted of aluminum, and the thickness may be about 10[µm].

FIG. 3 is a sectional view taken along a broken line A in FIG. 1 and FIG. 2. In FIG. 3, the P type first semiconductor layer 102A, a P type second semiconductor layer 102B, a N+ type semiconductor layer 143, an antireflection film 31, and a oxide film 32 described below are shown in addition to the parts shown in FIG. 1 and FIG. 2.

The P type first semiconductor layer 102A is formed in a region excluding the N+ type semiconductor layer 143 among the light transmitting surface of the single crystal N type semiconductor substrate 101. The P type first semiconductor layer 102A, together with the single crystal N type semiconductor substrate 101, generates photo-generated carriers based on mainly medium and long wavelength beam among the solar beam 130. In the P type first semiconductor layer 102A, the sheet resistance, for example, may be 10[Ω/sq.]-200[Ω/sq.], and the impurity concentration, for example, may be 10²⁰[cm⁻³]-10¹⁸[cm⁻³].

Although the P type first semiconductor layer 102A may be formed by a manufacturing process described below, in place of this process, by forming a groove in the single crystal N type semiconductor substrate 101, or, first, providing a semiconductor substrate of a solar battery cell of approximately equal thickness as the thickness of 200[µm] of the single crystal N type semiconductor substrate 101, next, making a micro cell structure by sectioning it suitably in X and Y direction, finally, by forming a wall-shaped groove on a side surface between the micro cell, the P type first semiconductor layer 102A may be formed together with the second electrode 172 in the groove. In such a case, since the area of the second electrode 172 may be made larger, the photoelectric conversion characteristics of the solar battery cell 100 may be further improved.

The P type second semiconductor layer 102B is formed in a manner covering the light incident surface and the side surface of the single crystal N type semiconductor substrate 101.In addition, for the P type second semiconductor layer 102B, from the viewpoint of recombination prevention of photo-generated carriers, although it is not essential to form in a manner to cover even the side surface of the single crystal N type semiconductor substrate 101 which is a small area, according to the manufacturing process described below, the side surface is also manufactured to cover integrally.

The P type second semiconductor layer 102B, together with the single crystal N type semiconductor substrate 101, generates photo-generated carriers by the solar beam of mainly short wavelength among the solar beam 130. The P type second semiconductor layer 102B may be made the conditions that the sheet resistance, for example, is 100 [Ω/sq.], the impurity concentration, for example, is 10²⁰[cm⁻³]-10¹⁸[cm⁻³], and the thickness is able to generate photo-generated carriers based on the solar beam of where the wavelength λ, for example, is 0.45[µm] or less, further 0.3[µm] or less among the solar beam 130.

Further, the condition that the wavelength λ is 0.45[µm] or less is the same meaning as the number of photons to generate photo-generated carriers is about 5[%]-10[%] of the total number of photons among the whole of the solar beam 130, and the condition that the wavelength λ is 0.3[µm] or less is the same meaning as the number of photons to generate photo-generated carriers is about 0[%] of the total number of photons among the whole of the solar beam 130.

Here in, in the present embodiment, for the surface of the single crystal N type semiconductor substrate 101, except for the formation portion of the N+ type semiconductor layer 143 corresponding to the first electrode 171, the P type second semiconductor layer 102B or the P type first semiconductor layer 102A is formed over the entire surface.

Then, the built-in potential of PN junction of the light incident surface side based on the single crystal N type semiconductor substrate 101 and the P type second semiconductor layer 102B is the same as the built-in potential of PN junction of the light transmitting surface side based on the single crystal N type semiconductor substrate 101 and the P type first semiconductor layer 102A.

Each built-in potential may be adjusted the impurity concentration of the P type second semiconductor layer 102B and the P type first semiconductor layer 102A against the single crystal N type semiconductor substrate 101. Specifically, since the built-in potential is proportional to the acceptor concentration of the P type second semiconductor layer 102B and the P type first semiconductor layer 102A, these concentrations may be the same.

The N+ type semiconductor layer 143 is provided on the light transmitting side and is a semiconductor layer for taking out electric signals connected to the first electrode 171. The impurity concentration of the N+ type semiconductor layer 143 may be, for example, 3 × 10²⁰[cm⁻³]-3 × 10¹⁸[cm⁻³]. In addition, in FIG. 3, although the thing of stripe-shape is shown as the shapes of the P type first semiconductor layer 102A and the N+ type semiconductor layer 143, instead of this, by applying a dot-shape for the one of them or a grid-shape, the area ratio of the N+ type semiconductor layer 143 against the P type first semiconductor layer 102A, for example, may be decreased to about 10[%].

The antireflection film 31, at the light incident surface side of the P type second semiconductor layer 102B, is formed between the bus bar wiring 170. The antireflection film 31, but is not limited to, may be used such as nitride film (SiN). In addition, here in, although the shape of the antireflection film 31 is simplified, actually, for example, it has a texture structure of an inverted pyramid style.

The oxide film 32, as known, is a passivation film provided on the light transmitting surface side in order to suppress the recombination current on the light transmitting surface.

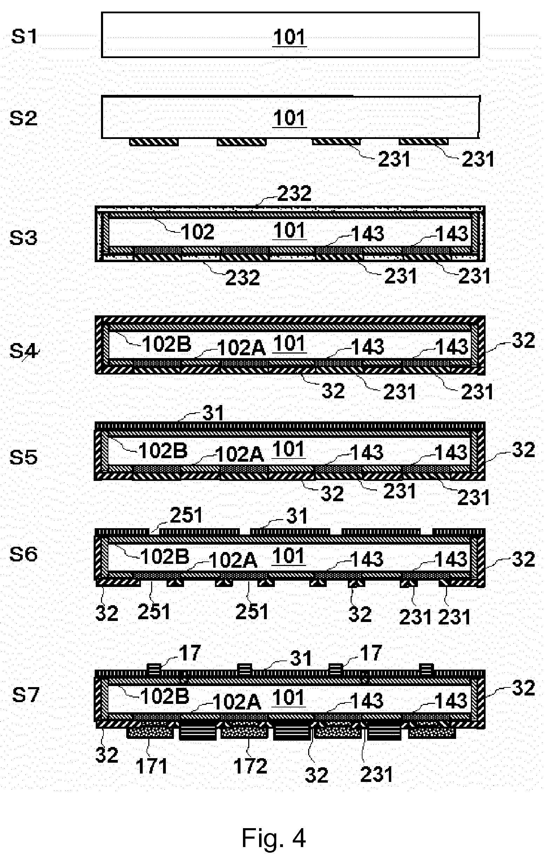

FIG. 4 is a manufacturing process diagram of a solar battery cell 100 shown in FIG. 3. First, in order to remove the damage of the single crystal N type semiconductor substrate 101, both surfaces of the single crystal N type semiconductor substrate 101 are etched about 10[µm], for example, using hydrofluoric acid. Then, anisotropic etching is performed by such as immersion in alkaline solution (for example, KOH solution) to at least the light incident surface of the single crystal N type semiconductor substrate 101. Thus, at least at the light incident surface of the single crystal N type semiconductor substrate 101, the textured structure of an inverted pyramid style (not shown) is formed under the condition, for example, that the base is about 30[µm] and the height is about 20[µm] (step S1).

After that, in order to perform a phosphorus injection on the back surface of the single crystal N type semiconductor substrate 101 by a subsequent process, a phosphorus glass layer 231 is formed by coating a phosphorus glass, for example, to the back surface of the single crystal N type semiconductor substrate 101. Then, the other portion is removed by photolithography in a manner to leave the necessary portions of the phosphorus glass (step S2)

And then, the single crystal N type semiconductor substrate 101 is performed a heat treatment at a temperature of about 900 °C under boron atmosphere, for example. The heat treatment time may be the condition that the deposition amount of boron into the single crystal N type semiconductor substrate 101 is about 10²⁰[cm⁻³], for example. As a result, boron diffuses into the single crystal N type semiconductor substrate 101 in a manner that the sheet resistance is 100[Ω/sq.] in the case that the diffusion depth is about 0.1 [µm]. Consequently, the P type first semiconductor layer 102A and the region of the P-type semiconductor layer 102 to be the P type second semiconductor layer 102B are formed in the single crystal N type semiconductor substrate 101, and, the surface of the single crystal N type semiconductor substrate 101 is entirely covered with a boron glass layer 232. In addition, in Figure 3, for the convenience of description, although it is not shown that the boron glass layer 232 on the surface of the phosphorus glass layer 231 forms a laminated state, actually, the boron glass layer 232 slightly forms a laminated state on the surface of the phosphorus glass layer 231. Further, by this heat treatment, the phosphorus in the phosphorus glass layer 231 coated in step S3 diffuses into the single crystal N type semiconductor substrate 101, and, the N+ type semiconductor layer 143 is formed in the single crystal N type semiconductor substrate 101 (step S3).

In the next, the single crystal N type semiconductor substrate 101, for example, under oxidizing atmosphere, is performed a heat treatment under the temperature of about 950[°C]. The heat treatment time may be a sufficient time for which the boron glass layer 232 is replaced with the oxide film 32 (step S4).

And then, after removing the oxide film 32 on the light incident surface side of the single crystal N type semiconductor substrate 101, or, without removing the oxide film 32, the antireflection film 31 is formed, for example, by low temperature CVD method (step S5).

And then, in order to form the bus bar wiring 170 on the light incident surface side of the single crystal N type semiconductor substrate 101, and to form the first electrode 171 and the second electrode 172 on the light transmitting surface side of the single crystal N type semiconductor substrate 101 respectively, the opening 251 is formed at the corresponding position of the antireflection film 31 on the light incident surface side of the single crystal N type semiconductor substrate 101, and at the corresponding position of the oxide film 32 and the phosphorus glass layer 231 on the light transmitting surface side respectively (step S6).

After that, for example, a liquid phase aluminum is deposited on the surface of the antireflection film 31 on the light incident surface side of the single crystal N type semiconductor substrate 101, and on the surfaces of the oxide film 32 and the phosphorus glass layer 231 of the light transmitting surface side, then, in order to diffuse the aluminum also in each of the openings 251, for example, a heat treatment is performed at a temperature of about 800[°C]. Thereafter, using a sputtering or vapor deposition method, aluminum is formed with a thickness of about 3[µm] on the light incident surface, and with a thickness of about 10[µm] on the light transmitting surface, then, an exposure is performed using such as a photolithographic method. For this exposure, a double-sided exposure of the light incident surface and the light transmitting surface is preferable. Thereafter, the aluminum excluding the portion serving as the bus bar wiring 170, the first electrode 171 and the second electrode 172 is removed by chemical etching such as wet etching or dry etching using necessary chemicals. However, the bus bar wiring 170, the first electrode 171 and the second electrode 172 may be formed using a paste method instead of the method described above (step S7).

And then, a plurality of intermediate products of the solar battery cell 100 manufactured in this way are prepared and they are superimposed. And then, the side surface electrode 173 is formed by such as spraying aluminum towards their side surfaces.

Further, the intermediate products of the solar battery cell 100 are superimposed with shifting slightly so that the formation surface of the side surface electrode 173 becomes a step shape. Further, by making them tilt rotation, not only the side surface electrode 173, the main bus bar at a light incident surface 174 may also be formed integrally with this. Furthermore, it enables to connect the main bus bar at a light incident surface 174 and each of the bus bar wiring 170, and also enables to connect the side surface electrode 173 and the second electrode 172.

Indeed, in the formation of the side surface electrode 173, as known, a metal paste such as an aluminum paste may be adopted, a metal vapor deposition (including sputtering) may be adopted, and a plating method may be adopted. Through the above steps, a plurality of the solar battery cells shown in FIG. 1 is completed.

And then, a behavior of the solar battery cell 100 of the present embodiment is described. When the solar beam 130 enters the solar battery cell 100, the solar beam having the ultraviolet beam region or shorter wavelength which the wavelength λ is 0.45[µm] or less among the solar beam 130, that is, when the solar beam having short wavelength reaches the PN junction of the light incident surface of the single crystal N type semiconductor substrate 101 and the P type second semiconductor layer 102B, the photo-generated carriers based on the solar beam are generated.

Holes generated by the above drift toward a depletion layer formed in the vicinity of the PN junction of the light incident surface of the single crystal N type semiconductor substrate 101 and the P type second semiconductor layer 102B, and when they reach the depletion layer, they may be taken out as electric signals from the bus bar wiring 170 and the main bus bar at a light incident surface 174 connected thereto.

On the other hand, the solar beam having the visible beam region or longer wavelength which the wavelength λ is greater than 0.45[µm] among the solar beam 130 entered to the solar battery cell 100, that is, when the solar beam having middle and long wavelength reaches the PN junction of the light transmitting surface of the single crystal N type semiconductor substrate 101 and the P type first semiconductor layer 102A, the photo-generated carriers based on the solar beam are generated.

Holes generated by the above, mainly, drift toward a depletion layer formed in the vicinity of the PN junction of the light transmitting surface of the single crystal N type semiconductor substrate 101 and the P type first semiconductor layer 102A, and when they reach the depletion layer, they may be taken out as electric signals from the second electrode 172.

In other words, since the holes generated by the solar beam 130 entering the solar battery cell 100 is only necessary to reach the one of depletion layers formed in the vicinity of each of the PN junction described above, the diffusion length of the holes may be shorter. For this reason, in the present embodiment, as described above, the thickness of the single crystal N type semiconductor substrate 101 may be relatively thin. Then, since the recombination of photo-generated carriers may be reduced by diffusion length of holes is short, the photoelectric conversion efficiency of the solar battery cell 100 is improved.

Furthermore, since the fact that it is possible to reduce the recombination of photo-generated carriers means to be able to take out the electric signals based on the photo-generated carriers prior to the recombination from the main bus bar at a light incident surface 174, and, since the electrical signals may be added to the output of the whole of the solar battery cell 100, the photoelectric conversion efficiency of the whole of the solar battery cell 100 is improved.

In the next, briefly, the photoelectric conversion efficiency of the solar battery cell 100 of the present embodiment tries to be simulated from a viewpoint of the voltage drop (IR drop). First, assume that the current according to the PN junction of the light incident surface side of the single crystal N type semiconductor substrate 101 and the P type second semiconductor layer 102B is 200mA, and the current according to the PN junction of the light transmitting surface side of the single crystal N type semiconductor substrate 101 and the P type first semiconductor layer 102A is 12A. In this case, the IR drop in the single crystal N type semiconductor substrate 101 is about 66 [mV] (≒ 5.4[mΩ] × 12.2[A]).

And then, since the resistance value of the P type second semiconductor layer 102B is about 37[mΩ] in the case of conditions described above, the IR drop in the P type second semiconductor layer 102B becomes 7.4[mV] (= 37.0[mΩ] × 200[mA]). Similarly, since the resistance value of the bus bar wiring 170 is about 250[mΩ] in the case of conditions described above, the IR drop in the main bus bar at a light incident surface 174 becomes 50[mV] (= 250[mΩ] × 200[mA]).

Then, since the resistance value of the side surface electrode 173 is small, and since the voltage drop in these is negligible small, the sum of the voltage drop which the current based on the short wavelength beam among the solar beam 130 entered on the solar battery cell 100 undergoes during passing through the PN junction of the light incident surface side of the single crystal N type semiconductor substrate 101 and the P type second semiconductor layer 102B, the bus bar wiring 170, the main bus bar at a light incident surface 174, and the side surface electrode 173 is about 126[mV] (≒ 66[mV] + 57.4[mV]).

Similarly, when looking at the voltage drop of the light transmitting surface side, the IR drop in the P type first semiconductor layer 102A is about 65[mV] (≒5.4[mΩ] × 12[A]). Therefore, the sum of the voltage drop which the current based on the medium and long wavelength beam among the solar beam 130 entered on the solar battery cell 100 undergoes during passing through the PN junction of the light transmitting surface side of the single crystal N type semiconductor substrate 101 and the P type first semiconductor layer 102A, and the second electrode 172 is about 131 [mV] (= 66[mV] + 65 [mV]).

In this case, when both open circuit voltages in each PN junction of the light incident surface side and the light transmitting surface side are assumed as 750[mV], the voltages in both PN junctions in the behavior state of the solar battery cell 100 are 624[mV] (=750[mV] - 126[mV]) and 619[mV] (=750[mV] - 131[mV]) respectively.

The powers in both PN junction at this time are 0.12[W] (≒624[mV] × 200[mA]) and 7.43[W] (≒619[mV] × 12[A]) respectively, these total becomes 7.55[W] (= 0.12[W] + 7.43[W]). In the case that the conversion of the power per square meter is performed, since this is 378[W], the photoelectric conversion efficiency is about 37.8[%].

According to the above simulation, since it becomes possible to collect electrical signals based on the solar beam of medium and long wavelengths by forming a P type first semiconductor layer 102A, and, since it becomes possible to collect photo-generated carriers which do not reach the P type first semiconductor layer 102A by forming the P type second semiconductor layer 102B, the solar battery cells 100 of the present embodiment may prevent the recombination of photo-generated carriers.

Further, with regard to the bus bar wiring 170, in the case that the width, the length, the thickness are changed to about 10[µm], about 10[µm], about 75[mm] respectively with regard to the size, and in the case that the aperture ratio of the solar battery cell 100 is changed to about 90[%] by changing the number to 3,000 pieces, and in the case that the other conditions described above are kept the same, the photoelectric conversion efficiency will be improved to about 46.2[%].

### Embodiment 2

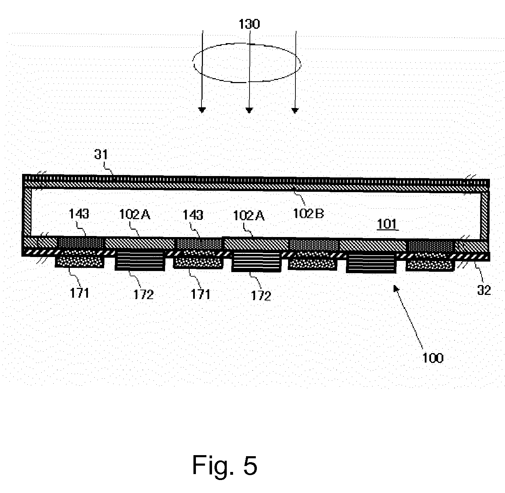

FIG. 5 is a schematic sectional view of the solar battery cell 100 of Embodiment 2 of the present invention and corresponds to FIG. 3. The solar battery cell 100 shown in FIG. 5 is of the type that the bus bar wiring 170, the main bus bar at a light incident surface 174 and the side surface electrode 173 shown in FIG. 3 are not provided. In FIG. 5, the portions similar to the portions shown in FIG. 3 are denoted by the same reference numerals.

Since the solar battery cell 100 shown in FIG. 5 is not provided with such as the bus bar wiring 170, the sheet resistance value of the P type second semiconductor layer 102B defines a upper limit value of electrical signals generated in the PN junction of the light incident surface side of the P type second semiconductor layer 102B and the single crystal N type semiconductor substrate 101.

Although the upper limit value is preferable as large value as possible, since the P type second semiconductor layer 102B is composed of a semiconductor, when the sheet resistance of the P type second semiconductor layer 102B is set to 1[Ω/sq.] or above, the electrical signals generated in the PN junction of the light incident surface side of the P type second semiconductor layer 102B and the single crystal N type semiconductor substrate 101 are always smaller than the electrical signals generated in the PN junction of the light transmitting surface side of the P type first semiconductor layer 102A and the single crystal N type semiconductor substrate 101 (including zero).

Then, since there is an upper limit to an electrical signal generated in PN junction of the light incident surface side of the P-type second semiconductor layer 102B and the single crystal N type semiconductor substrate 101, more electrical signals are obtained at the PN junction of the light transmitting surface side of the P-type first semiconductor layer 102A and the single-crystal N type semiconductor substrate 101, specifically, in the case of solar battery cells manufactured by above and below conditions, 99.9[%] or above of the total generated current may be obtained from the PN junction of the light transmitting surface side of the P-type first semiconductor layer 102A and the single-crystal N type semiconductor substrate 101.

In the present embodiment, the P type second semiconductor layer 102B, for example, may be formed by an ion implantation method. For the P-type second semiconductor layer 102B formed on the light incident surface of the single crystal N type semiconductor substrate 101, boron is selected as impurities, and the diffusion depth may be the same depth as Embodiment 1, for example, about 0.1[µm].

Furthermore, the P-type second semiconductor layer 102B and the P-type first semiconductor layer 102A covering the side surfaces of the single crystal N type semiconductor substrate 101, for example, may be formed by a diffusion method in the liquid phase. For these, aluminum or a multilayer structure of aluminum and boron may be selected as impurities, and each diffusion depth may be set to 0.5[µm], for example.

Indeed, as long as the conditions that may collect photo-generated carriers based on photons of majority of the solar light spectrum generated by the PN junction of the light transmitting surface side of the P-type first semiconductor layer 102A and the single-crystal N type semiconductor substrate 101, both manufacturing methods of the P-type second semiconductor layer 102B and the P-type first semiconductor layer 102A, and, each impurity concentration and each diffusion depth are not limited to those described above.

Therefore, for example, in place of the ion implantation method, the correspondences such as adopting the doping from the impurity source of solid, liquid or gas, and, selecting each diffusion depth, for example, as 0.2[µm] as well as selecting only boron as impurities with respect to both of the P-type second semiconductor layer 102B and the P-type first semiconductor layer 102A are also possible.

Further, similarly to Embodiment 1, although it is not essential to form the P-type second semiconductor layer 102B for covering the side surfaces of the single crystal N type semiconductor substrate 101 among the P-type second semiconductor layer 102B, there is also advantage of forming it.

Specifically, different from Embodiment 1, for the solar battery cell 100 of the present embodiment, since the bus bar wiring 170, the main bus bar at a light incident surface 174 and the side surface electrode 173 are not provided, the current based on the carrier reached at the P-type second semiconductor layer 102B must be taken out to the outside of the solar battery cell 100. In this regard, separately, although measures such as performing a positive power supply connection to the P-type second semiconductor layer 102B may be considered, when the P-type second semiconductor layer 102B is provided, since this is to function as a path flowing through the P-type second semiconductor layer 102B, there is an advantage that the positive power supply connection becomes unnecessary.

Moreover, in the present embodiment, the built-in potential of the PN junction of the light incident surface side of the single crystal N type semiconductor substrate 101 and the P-type second semiconductor layer 102B is to be higher than the built-in potential of the PN junction of the light transmitting surface side of the single crystal N type semiconductor substrate 101 and the P-type first semiconductor layer 102A. Alternatively, toward the joining direction from the central portion of the single crystal N type semiconductor substrate 101, the concentration gradient such as to increase the ion concentration of the single crystal N type semiconductor substrate 101 may be provided. For this purpose, against the manufacturing method described in Embodiment 1, prior to the treatment under boron atmosphere, by deposition of phosphorus or antimony, N layer with a high concentration (for example, 10¹⁷[cm⁻³]-10¹⁸[cm⁻³]) than the single crystal N type semiconductor substrate 101 may be formed on the inside of the boron layer of the single crystal N type semiconductor substrate 101. However, the correspondence of providing a concentration gradient may be employed at the time that both of the built-in potentials are the same in the solar battery cell 100 of Embodiment 1.

For example, when the acceptor concentration of the P-type second semiconductor layer 102B is increased about two digits as compared to the acceptor concentration of the P-type first semiconductor layer 102A, the difference of about 120[mV] occurs between those built-in potentials. Specifically, the acceptor concentration of the P-type second semiconductor layer 102B, the acceptor concentration of the P-type first semiconductor layer 102A, and the donor concentration of the single crystal N type semiconductor substrate 101, for example, may be set to 10²⁰[cm⁻³], 10¹⁸[cm⁻³], and 10¹⁶[cm⁻³] respectively. With such a setting, electrons of minority carriers generated in the single crystal N type semiconductor substrate 101 become to flow beyond the barrier from the PN junction of the light transmitting surface of the low barrier. In addition, the impurity concentration in the present specification refers to the average concentration in the semiconductor layer in which impurities are contained.

Additionally, when the acceptor concentration of the P-type second semiconductor layer 102B is smaller than the acceptor concentration of the P-type first semiconductor layer 102A, on the contrary, electrons of minority carriers generated in the single crystal N type semiconductor substrate 101 become to flow beyond the barrier from the PN junction of the light incident surface of the low barrier, when both acceptor concentrations are equal, electrons move toward the PN junction corresponding to wavelength of the light spectrum.

Although the solar battery cell 100 of the present embodiment is inexpensive manufacturing cost by a simple structure as compared with that of Embodiment 1, the open circuit voltage of the PN junction of the light transmitting surface may be the same value as that of Embodiment 1. As a result, the photoelectric conversion efficiency of the solar battery cell 100 of the present embodiment comes to about 37.8[%].

### Embodiment 3

In the present embodiment, a modified example against the Embodiments 1 and 2 described above is described based on FIG. 4.

In the single crystal N-type semiconductor substrate 101 shown in step S1, the specific resistance, for example, is set to 1[Ω·cm]-10[Ω · cm], and, the impurity concentration is set to 5 × 10¹⁵[cm⁻³]-5 × 10¹⁴[cm⁻³].

In step S2, first, the oxide film, for example, is formed by a heat treatment method on the entire surface of the single crystal N type semiconductor substrate 101. After that, only the oxide film on the back surface portion of the single crystal N type semiconductor substrate 101 is removed. And, for example, phosphorus glass is coated first on the back surface of the single crystal N type semiconductor substrate 101, and the phosphorus glass layer 231 is formed. In addition, since boron is also injected in addition to the purpose of injecting phosphorus into the back surface of the single crystal N type semiconductor substrate 101, for example, the boron glass layer is formed by superposing the phosphorus glass layer 231 by a coating method.

The heat treatment time performed in step S3 may be in the conditions where the impurity concentration of boron into the single crystal N-type semiconductor substrate 101, for example, is about 10¹⁸[cm³], and the thickness is about 0.5[µm]. In this case, boron diffuses in a manner that the sheet resistance is 100[Ω/sq.]. As a result, the region to be the P-type first semiconductor layer 102A is formed in the single crystal N type semiconductor substrate 101. In this heat treatment, at the same time, when the deposition amount of phosphorus from the phosphorus glass layer 231, for example, is 3 × 10¹⁹[cm⁻³]-10¹⁸[cm⁻³], the N+ type semiconductor layer 143 having substantially the same diffusion depth (thickness) as the P-type first semiconductor layer 102A is formed.

Further, regard to the formation of the P-type second semiconductor layer 102B, besides the illustrative example described above, for example, a gas phase diffusion method, a liquid phase diffusion method, an ion implantation method, and a coating diffusion method from boron bromide BBr3 may be used. In addition, in the manufacturing process according to the present modified example, the boron glass layer 232 is not formed in the implementation stage of step S3.

In step S4, the oxide films on the light incident surface and the side surface of the single crystal N type semiconductor substrate 101 are removed among the oxide film formed in step S2. Then, for example, by vaporizing boron bromide and under oxygen atmosphere, the single crystal N type semiconductor substrate 101 is performed a heat treatment at a temperature of about 950[°C]. Heat treatment time is set so that the P-type second semiconductor layer is formed with a thickness of about 0.1 [µm] and the impurity concentration is formed with 10¹⁹[cm⁻³]. In this time, the boron glass layer 232 is formed on the light incident surface and the side surface of the single crystal N type semiconductor substrate 101.

In step S5, after removing the boron glass layer 232 of the light incident surface side of the single crystal N type semiconductor substrate 101, or, without removing the boron glass layer 232, the antireflection film 31 is formed by low temperature CVD method, for example.

In Step S6, at the corresponding position of the antireflection film 31 of the light incident surface side of the single crystal N type semiconductor substrate 101, and at the corresponding position in the case that the phosphorus glass layer 231 and the boron glass layer 232 of the light transmitting surface side were not removed, the openings 251 are formed respectively.

In Step S7, for example, after depositing aluminum on the surface of the antireflection film 31 of the light incident surface side of the single crystal N type semiconductor substrate 101, and on the surfaces of the phosphorus glass layer 231 and boron glass layer of the light transmitting surface side, in order to diffuse aluminum to each of the openings 251, for example, the heat treatment is performed at a temperature of about 400[°C]. After that, after film formation of aluminum by a sputtering or vapor deposition method with the thickness of about 3[µm] on the light incident surface, and with the thickness of about10[µm] on the light transmitting surface, the exposure is performed using such as a photolithographic method. For this exposure, the double-sided exposure of the light incident surface and the light transmitting surface is preferable. After that, the aluminum except the portion to be the bus bar wiring 170, the first electrode 171 and the second electrode 172 is removed by chemical etching such as wet etching or dry etching using necessary chemicals.

When the solar battery cell 100 is manufactured by the conditions described above, the built-in potential of the PN junction of the light incident surface side of the single crystal N type semiconductor substrate 101 and the P-type second semiconductor layer 102B may be as high as about 60[mV] than the built-in potential of the PN junction of the light transmitting surface side of the single crystal N type semiconductor substrate 101 and the P-type first semiconductor layer 102A.

This is the same meaning that the impurity concentration of the P-type second semiconductor layer 102B is made larger to almost one digit or more as compared with the impurity concentration of the P-type first semiconductor layer 102A, specifically, the impurity concentration of the P-type second semiconductor layer 102B, for example, is 10²⁰[cm⁻³]-10¹⁹[cm⁻³], the impurity concentration of the P-type first semiconductor layer 102A, for example, is 10¹⁹[cm⁻³]-10¹⁸[cm⁻³], and the impurity concentration of the single crystal N-type semiconductor substrate 101, for example, is 5 × 10¹⁵[cm⁻³]-5 × 10¹⁴[cm⁻³]. For the P-type first semiconductor layer 102A, the sheet resistance, for example, is 20[Ω/sq.]-200[Ω/sq.]. The thickness, for example, is 0.5[µm].

In the case of such setting, 90[%] of generated carriers in the single crystal N type semiconductor substrate 101 flows beyond the barrier from the PN junction of the light transmitting surface of the low barrier. In such a case, when calculating the photoelectric conversion efficiency of the solar battery cell 100 in the manner described in Embodiment 1, it is improved to 44.9[%].

Furthermore, for the condition of each layer described in Embodiment 2, in the case that the impurity concentration of the P-type second semiconductor layer 102B, for example, is 10²⁰[cm⁻³]-10¹⁹[cm⁻³], the impurity concentration of the P-type first semiconductor layer 102A, for example, is 10¹⁸[cm⁻³]-10¹⁷[cm⁻³], and the impurity concentration of the single crystal N type semiconductor substrate 101, for example, is 5 × 10¹⁵[cm⁻³]-5 × 10¹⁴[cm⁻³], about 99[%] of generated carriers in the single crystal N type semiconductor substrate 101 flows beyond the barrier from the PN junction of the light transmitting surface of the low barrier.

In the case of solar battery cells 100 having such conditions, almost 99[%] of the total generated current may be obtained from the PN junction of the light transmitting surface side of the P-type first semiconductor layer 102A and the single-crystal N type semiconductor substrate 101. In addition, the photoelectric conversion efficiency of the solar battery cell 100 in this condition is approximately 36.7[%].

## Claims

1. A solar battery comprising:
a semiconductor substrate of a first conductivity type;
a first semiconductor layer of a second conductivity type formed at a light transmitting surface of the semiconductor substrate and collecting photo-generated carriers based on solar beam of middle and long wavelength; and
a second semiconductor layer of a second conductivity type formed at a light incident surface of the semiconductor substrate and collecting photo-generated carriers which do not reach a first semiconductor layer among photo-generated carriers based on the solar beam of middle and long wavelength as well as collecting photo-generated carriers based on solar beam of short wavelength;
wherein an impurity concentration of the second semiconductor layer is larger to almost one digit or more as compared with an impurity concentration of the first semiconductor layer.

2. The solar battery according to claim 1, wherein the first semiconductor layer is formed in a manner in contact with the overall to the light transmission surface of the semiconductor substrate except for formation locations of a semiconductor layer of a first conductive type connected to electrodes for taking out electric signals based on photo-generated carriers collected at the first semiconductor layer.

3. The solar battery according to claim 1, wherein a current outputted from the second semiconductor layer and a current outputted from the first semiconductor layer are added and outputted.

4. The solar battery according to claim 1, wherein the semiconductor substrate is covered with the first semiconductor layer and the second semiconductor layer except for formation locations of a semiconductor layer of a first conductive type connected to electrodes for taking out electric signals based on photo-generated carriers collected at the first semiconductor layer.

5. The solar cell according to claim 1, wherein a current value outputted from the first semiconductor layer is larger than a current value outputted from the second semiconductor layer.

6. A manufacturing method of a solar battery including:
a step of forming a first semiconductor layer of a second conductivity type collecting photo-generated carriers based on solar beam of middle and long wavelength at a light transmitting surface of a first conductivity type;
a step of forming a second semiconductor layer of a second conductivity type collecting photo-generated carriers which do not reach a first semiconductor layer among photo-generated carriers based on the solar beam of middle and long wavelength as well as collecting photo-generated carriers based on solar beam of short wavelength at a light incident surface of the semiconductor substrate; and
a step of increasing an impurity concentration of the second semiconductor layer almost one digit or more as compared with an impurity concentration of the first semiconductor layer.
